# EUROPEAN PATENT APPLICATION

(11) **EP 0 564 389 A1**
(43) Date of publication of application: **06.10.1993**
(21) Application number: 93480026.9
(22) Date of filing: 23.03.1993
(51) Int. Cl.: G03F 7/004

(54) **Stabilized chemically amplified positive resist composition containing glycol ether polymers**

(30) Priority: 01.04.1992 US 861695
(71) Applicant: International Business Machines Corporation, Armonk, N.Y. 10504 (US)
(72) Inventor: Fahey, James Thomas, Poughkeepsie, N.Y. 12603 (US); Khojasteh, Mahmoud Mostafa, Wappingers Falls, NY 12590 (US); Nunes, Ronald Wayne, Hopewell Junction, NY 12533 (US); Wood, Robert Lavin, Poughkeepsie, NY 12603 (US); Perreault, Stanley Eugene, Wappingers Falls, NY 12533 (US); Spinillo, Gary Thomas, Wappingers Falls, NY 12590 (US); Welsh, Kevin Michael, Fishkill, NY 12586 (US)
(74) Representative: Klein, Daniel Jacques Henri

(57) **Abstract**

Chemically amplified, positive resist compositions containing hydroxy terminated non-ionic polyglycol type surfactants, are described. These polyglycol containing compositions exhibit improved resist contrast by retarding the of absorption of environmental poison, such as organic and inorganic bases; which normally cause top surface image distortion on large silicon wafers.

## Description

### Background of the Invention

The present invention relates to lithographic, resists, which exhibit increased sensitivity. More particularly, it pertains to chemically amplified photoresist compositions which have increased sensitivity as a result of the presence of hydroxy terminated non-ionic polyglycol type surfactants. Such improved resist sensitivity results from the retardation of absorption of environmental poisons, such as organic and inorganic bases, which normally cause top surface image distortion on large silicon wafers.

In addition, these polyglycols also extend the dose latitude or dose window and improve the focus window of such chemically amplified resists to resolve submicron images.

These chemically amplified resist compositions contain hydroxy terminated non-ionic polyglycol type surfactants, which are polymers and copolymers of glycol ethers having ethylene oxide and propylene oxide repeating units. Similar improved stabilizer properties are achieved with polymers and coplymers of glycol ethers initiated on ethylene diamine.

The incorporation of these non-ionic surfactants provide, among other advantages, an unexpected increase in the contrast of the photoresist. By the addition of these hydroxy terminated non-ionic surfactants, an increase in the gamma( Contrast) from a typical photoresist contrast gamma value of 3 or less to a value of greater than 5 can be attained. The higher contrast photoresist provide superior line width control and afford improved processing latitude in photoresist imaging.

In addition, the presence of these hydroxy terminated non-ionic surfactants increases the dose latitude or dose window of a chemically amplified resist from an unacceptable ± 5% to ± 20%, which is highly desirable, since it provides greater operational latitude during the imaging process.

The art to produce positive photoresist formulations is well established for use in microelectronic applications. Such typical photoresist formulations include alkali-soluble phenol- formaldehyde novolak resins or poly(hydroxystyrene), together with light sensitive materials. The resins and sensitizers are dissolved in an organic solvent or mixture of solvents and are applied as a thin film or coating to a suitable substrate . The resin component of these photoresists formulations is soluble in aqueous alkaline solutions, but the sensitizer acts as a dissolution rate inhibitor with respect to the resin. Upon exposure of selected areas of the coated substrate to irradiation, however, the sensitizer undergoes a radiation induced structural transformation and the exposed areas of the coating are rendered more soluble than the unexposed areas. Photosensitizers act to decrease the solubility of the resins. Upon exposure to irradiation, the photosensitizer undergoes a chemical change resulting in the formation of a carboxylic acid; which increase the rate of solublization of the photoresist composition in the exposed areas.

This difference in solubility rates causes the exposed areas of the photoresist coating to be dissolved when the substrate is immersed in an alkaline developing solution while the unexposed areas are largely unaffected, thus producing a positive relief pattern on the substrate.

Critical properties that a photoresist composition must exhibit are resist resolution and development of contrast. By resist resolution is meant the capacity of the system to reproduce the finest features from the mask to the resist image on the substrate. Resolution in the order of one microns or less, is required for minaturized electronic components, such as ,integrated circuits on silicon chips and similar components.

The problem noted in optical exposure has been the fall off in contrast of line definition between areas of exposure and non-exposure. At the boundaries of such patterning there have been regions where there is (weak) exposure causing a gradient in the development that prevents the formation of sharp side walled images.

The use of photo-acid generators in chemically amplified positive is now well developed and has lead to several important resists for advanced lithography. Numerous acid catalyzed novolak resin type resists are now under commercial development. One of the common liabilities to these resists results from the vulnerability of the photo-acid formed by exposure near the resist surface. For example, in positive tone resists, loss of acid near the surface through poisoning by environmental agents and / or volatilization, leads to insolubilzation of the surface layer, resulting in the well known skin and T-top distortion effects. These effects are evident in positive resists and result in poor process latitude and demanding process control measures.

Attempts to use more robust or less volatile acids have not been successful in eliminating these effects since they impose too severe a penalty, defeating the advantage of chemical amplification.

The applicant is aware of several references which are listed below. The pertinence of these references to the current invention, will be considered and discussed later on.

US-A- 4.725.526 describes copolymers of ethylene oxide, propylene oxide used in printing applications.

US-A- 4.576.903 describes a developer solution which is suitable for developing positive photoresists; containing ethoxylated alkylphenols.

US-A- 4.670.372 also describes a developer solution, a component of which is a carboxylated surfactant salt.

US-A- 4.946.759, describes the formulation of a positive photo-resist which may optionally contain a polyglycol or cellulose ether.

US-A- 4.863.827 describes the optional use of a nonionic surfactant alkylsubstituted phenoxy poly(ethyleneoxy) ethanol in multilevel resists.

This invention relates to an improved chemically amplified positive resist compositions, containing nonionic polymer or copolymers of ethylene glycol ethers containing ethylene oxide and propylene oxide repeating units, which retard the absorption of environmental poisons such as organic and inorganic bases. These novel compositions result in improved resolution of the resultant positive photo-resist relief structures.

Moreover, the invention represents a novel composition which has the effect of modulating the catalytic chain-length in the chemically amplified resists; resulting from the presence of the hydroxy terminated non-ionic polymers. This modulation has been shown to be useful in reducing the sensitivity of these resists to the effects of acid loss. .Such acid loss results in surface insolubilization, which leads to undesirable skin and T top distortions and additionally a significant improvement in resistance to post exposure bake delays.

The chemically amplified positive resist resin compositions contain loadings of about 0.01% to about 15 % of these non-ionic surfactant polymers or copolymers, based on total resist solids, are effective in reducing surface insolubilization and its attendant surface distortions.

Preferably the composition contains 0.05 %, to 9.0%. of the hydroxy terminated non-ionic polymer or copolymer of ethylene glycol ethers containing ethylene oxide and propylene oxide repeating units.

Admittedly, nonionic surfactants having different functional groups including ethoxylated segments, have been for use in other phases of minaturized electronics processing and to satisfy different product needs. However none are of the type or have been employed to in a manner to facilitate obtaining the specific novel results of the present compositions .

Thus for example, in US-A- 4.725.526 , copolymers of ethylene oxide, propylene oxide and dimethyl dichlorosilane are described for use as lubricants in offset printing plates which are employed in the photosensitive layer. Such copolymers are distinctly different from the polyfunctional hydroxy terminated nonionic surfactant components of the resist composition of this invention.

On the other hand, US-A- 4.576.903 describes a developer solution which is suitable for developing positive photoresists; which contain (1-100 ppm) ethoxylated alkylphenol type non-ionic surfactants. The patent describes the surfactant as assisting in the dissolving of the irradiated exposed layer. Thus the surfactant is a component of the developer and not the photoresist resin composition; it does not function in the same capacity as the specific nonionic type coplymers of this invention.

Similarly, US-A- 4.670.372 also describes a developer solution, a component of which is a carboxylated surfactant salt, who_s cation is the same as the source from the alkaline base of the developer. Obviously this type of Ionic surfactant additive, although it may contain ethoxlated groups, is distinctly different from the non-ionic polymers added to the photo-resist resin of the instant application.

In US-A- 4.946.759, the inventor describes the formulation of a positive photo-resist which may optionally contain a polyglycol or cellulose ether to control flexibility, adhesion and promote gloss. Such broad and sweeping objectives , do not teach the specific addition of an non-ionic surfactant of the type cited in the instant application, to accomplish the objectives of the current invention. While acid-cleavable additives ,of the alkyl substituted phenyl glycol type are described , such compounds are distinctly different in structure from the hydroxy terminated polyglycols of the current invention.

The optional use of a non-ionic surfactant alkylsubstituted phenoxy poly(ethyleneoxy) ethanol is also noted in US-A- 4.863.827. This is intended for possible use in a positive multi-level photoresist composition. The use of the optional non-ionics are not defined in this multi-level photoresist, and the surfactants described are distinctly different from the type taught in the current invention.

It has now been found that greatly improved, chemically amplified positive resist compositions can be prepared by adding a hydroxy terminated polyglycol surfactant additives to the resist formulation. As noted above improved resist stability and contrast qualities are attained by retardation of the absorption of environmental poison such as organic and inorganic bases. These environmental poisons normally cause top surface image distortion on large silicon wafers.

For example, in positive tone resists, loss of acid near the surface through poisoning by environmental agents and / or volatilization leads to insolubilzation of the surface layer; resulting in the well known skin and T-top distortion effects. These effects are evident in chemically amplified positive resists derived the novolak or poly(hydroxystyrene) type and result in poor process latitude and demanding process control measures.

The polyglycol components of this composition are polymers and copolymers of glycol ethers having ethylene oxide and propylene oxide repeating units. Similar improved stabilizer properties are achieved with hydroxy terminated polymers and coplymers of glycol ethers initiated on ethylene diamine.

For example, the addition of these non-ionic surfactants, increases in the gamma( Contrast) from a typical photoresist contrast gamma value of 3 or less to a value of greater than 5. The higher contrast photoresist values provide superior line width control and afford greater processing latitude in photo resist imaging.

Another added advantage of the chemically amplified resists compositions of this invention is the significant increase in process latitude with respect to both dose window and focus control, as a direct result of the presence of these hydroxy terminated polyglycols in the resist composition. This is readily seen as an increase from a dose window of ± to one of ± 20% resulting from the addition of a polyglycol of the type claimed in this invention. In addition these polyglycols also decrease chemically amplified resist sensitivity from about 2 mJ to about 5-6 mJ, which is nevertheless quite desirable for deep UV imaging tools.

The compositions of the present invention are chemically amplified positive resists. These compositions comprise several components, the function of each of which will become apparent to those skilled in the art in light of the disclosure and claims provided hereby.

The resin matrix for the composition is soluble in aqueous alkaline developers. The resin may be any well-known aromatic resin where the hydroxy group is linked to an aromatic ring as a phenolic substituent. Included and preferred among such materials are poly( parahydroxystyrene) and copolymers of 4-hydroxystyrene and t-butoxy oxy carbonyl styrene( TBOC). A preferable resin of this type is an 80% /20% coplymer of 4-Hydroxy styrene and t-Butoxy oxy Carbonyl Styrene. The resin component may also be a phenol-formaldehyde condensation product (novolak), Cresol-formaldehyde, Bisphenol A novolak or other novolak resins.

EP-A- 388 343 the disclosure of which is incorporated by reference into the present application, discloses Chemically Amplified photoresist compositions having a polymeric or molecular composition whose solubility is dependent upon the presence of acid removable protecting groups and a sulfonic acid precursor which generates a strong acid upon exposure to radiation.

A sulfonic acid releasing material( Sensitizer) is included in this composition. US-A- 4.618.564 is directed to compositions comprising a film forming organic material consisting essentially of an aqueous base soluble resin and a substance which releases sulfonic acid upon exposure to activated radiation to make the exposed regions of the film more soluble to the aqueous developers. The sulfonic acid releasing materials include sulfonate esters and aromatic N-sulfonyloxyimides. These materials can be flood exposed after patterning and the substrate processing to make the remaining patterned layer soluble in aqueous base developer.

The preferred sulfonic acid generators for the present invention are sulfonyloxyimides of the form 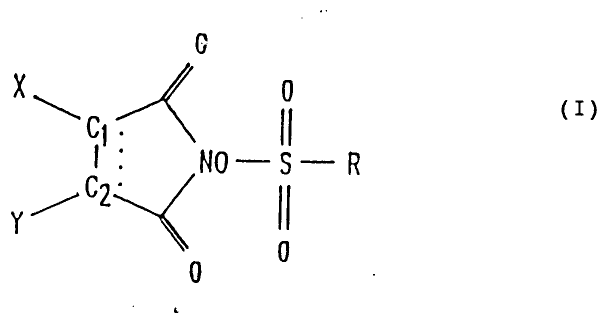
where C1 and C2 may form a single or double bond
wherein R is selected from -(CH2)n-z and -(CF2)n-z
wherein n= 0 to 4,
wherein z is H,F, alkylaryl 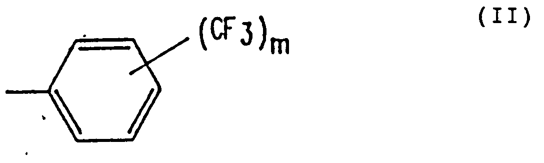 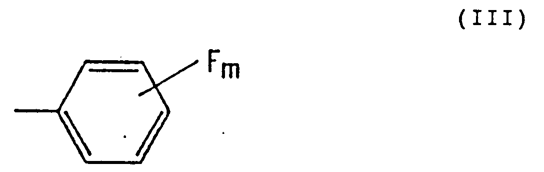
where m is from 1 to 5, provided that when z is H,F or alkylaryl n must be at least 1, and where x and y (1) form a cylic or polycyclic ring which may contain one or more hetero atoms, (2) form a fused aromatic ring, (3) may be independently H, alkyl or aryl, (4) may be attached to another sulfonyloxyimide containing residue, or (5) may be attached to a polymeric chain or backbone.

A preferred sensitizer described-for use in deep UV chemically amplified resists systems is trifluoromethylsulfonyloxybicyclo [2.2.1]-hept-5-ene-2,3-dicarboximide ( MDT ) and having the structure

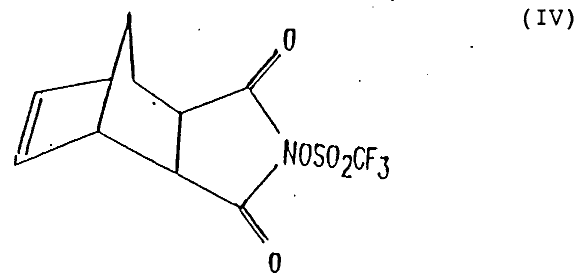

These esters of the sulfonic acid with an imide or oxime are present in an amount based on solids from about 1 to 20 weight percent, preferably from 5 to 10 weight percent.

The photoresist compositions of the present invention are formulated with an appropriate organic solvent. Typically, the solvent will be ethoxyethyl 2 propionate, ethyl lactate, ethyl cellosolve acetate, propylene glycol monoethyl ether acetate ( PM actate), ethyl acetate and ethyl lactate. Solvent mixtures may be used as well. Other suitable solvents are known in the art and may be used. The compositions will have from about 10 to 40 weght percent solids. The most preferred compositions have 15 to 25 weight percent solids.

The non-ionic hydroxy terminated polyglycol surfactant component of the current chemically amplified positive resist composition, are preferably polymers and copolymers of glycol ethers having ethylene oxide and propylene oxide repeat units. Similar results are achieved with ethylene diamine derived polymeric glycol ethers.

Typical of the nonionic additives which represent this invention are the Pluronic Surfactants supplied by BASF corporation under the trade name "Pluronics". The structure of these poly(oxyethylene-co-oxypropylene) nonionics is represented by the structure: 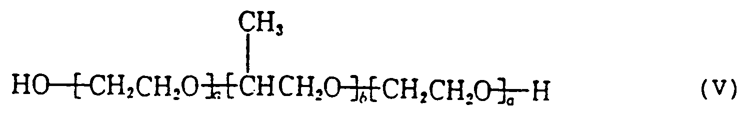
a = 1 to 100 b = 1 to 100
where the reaction is initiated by propylene glycol, and 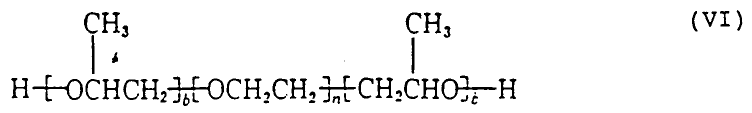
b = 1 to 100 n = 1 to 100
where the reaction is initiated by ethylene glycol.

Similar to the "Tetronic" series of non-ionics surfactants are poly(oxyethylene-co-oxypropylene) are similar in structure above however ethelene diamine is substituted for ethylene glycol as the initiating compound.

Typical structure of the BASF "Tetronic" non-ionic surfactants additives which are particularly effective in this composition as additives: 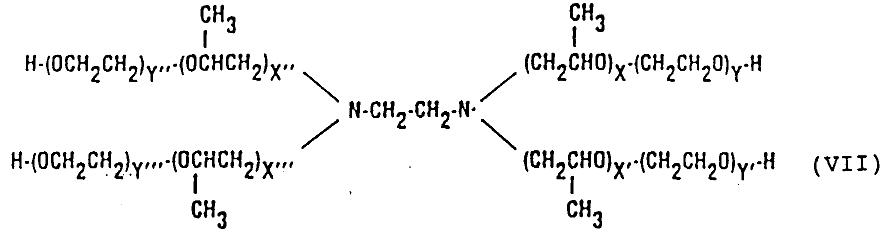
or 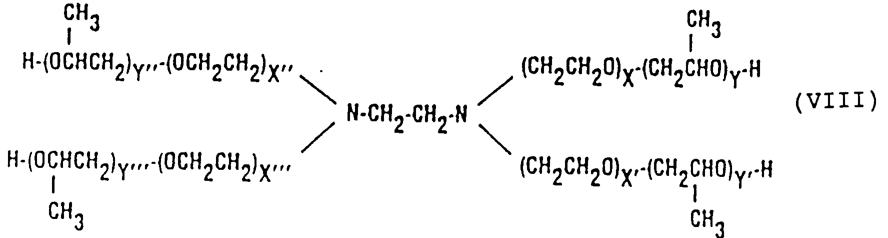
x', x'', x''', y, y'', y''', = 1 to 100

In practice of this invention, the amount of non-ionic hydroxy terminated polyglycol polymer additive employed, varies from 0.0001 percent to about 30% . The more effective level of the additive of the instant application ranges from 0.01% to about 15% and the preferred range of .0.% to 9%.

The following procedure is followed for preparing and evaluating the improved performance of the photo-resist system containing the additive of the current invention.

The photo resist coating is applied by spin coating on a silicon wafer, which is subsequently subject to a 60 to 120 degree C bake, preferably at 90 degrees C for about one minute. Wafers were exposed using a deep - UV mercury lamp exposure source at 10 mJ through a mask having a multi-density step-wedged pattern. Following exposure , the wafers were again baked at 60 to 120 degrees C , preferably at 90 degrees, for one minute, then developed in 0.21N aqueous tertramethyl ammonium hydroxide (TMAH) for 1 minutes. Measurements of the remaining thickness in the multi-density step wedge patterned area was used to determine resist sensitivity and contrast.

The following examples are illustrative of the invention. The enumeration of details in the examples should not be interpreted as limitations except as may be expresses in any appended claims.

### Example 1:

A photoresist coating of about 1 micrometer thick was prepared by the spin coating technique from a solution of a 18 grams of poly (4-t-Butoxy CarbonyloxyStyrene-co- 4-Hydroxystyrene) (PBOCST-PHOST) resin made in accordance with the disclosure of US-A- 366 590 80 grams of polyethyene glycol methyl ether acetate( PMA) solvent and 2 grams of trifluoromethylsulfonyl oxyicyclo - [ 2.2.1.]-hept-5-ene 2,3-dicarboximide(MDT), which is made in accordance with of U.S. application 322,848 (the disclosure of which is hereby incorporated by reference) photosensitizer.

The coated silicon wafer is then baked between 70 and 100 degrees C, preferably at 90 degrees C for 1 minutes on a hot plate to yield a 0.9 um film. The coated wafer was then exposed to deep ultraviolet radiation through a chrome mask on a Perkin-Elmer PE500 exposure tool with a setting for aperture 4 and received a 15 mJ/cm2 exposure. The exposed wafer was given another 90 second post exposure baked again at 90 degree C for one minute. The exposed photo-resist covered wafer is then immersed in a 0.21 N aqueous tertramethylammonium hydroxide developer( TMAH) solution for 60 seconds at 22 degrees C. The wafer was then removed from the developer bath, washed in deionized water and dried. The contrast and sensitivity data are shown in Table I.

### Example 2:

A photoresist coating of about 1 micrometer thick was prepared by the spin coating technique from a solution of a 18 grams of poly (4-t-Butoxy CarbonyloxyStyrene-co- 4-Hydroxystyrene) (PBOCST-PHOST) resin made in accordance with the disclosure of US-A- 366 590 79 grams of polyethyene glycol methyl ether acetate( PMA) solvent and 2 grams of trifluoromethylsulfonyl oxyicyclo - [ 2.2.1.]-hept-5-ene 2,3-dicarboximide(MDT), which is made in accordance with of US-A- 388 343 photosensitizer and 0.8 grams of "Tetronic 1501" hydroxy terminated nonionic polymer, supplied by the BASF corporation.

The subsequent procedure for baking, UV exposure, PEB and developing are identical to that of Example 1.

### Example 3:

A photoresist coating of about 1 micrometer thick was prepared by the spin coating technique from a solution of a 18 grams of poly (4-t-Butoxy CarbonyloxyStyrene-co- 4-Hydroxystyrene) (PBOCST-PHOST) resin made in accordance with the disclosure of US-A- 366 590 71 grams of polyethyene glycol methyl ether acetate( PMA) solvent and 2 grams of trifluoromethylsulfonyl oxyicyclo - [ 2.2.1.]-hept-5-ene 2,3-dicarboximide(MDT), which is made in accordance with of US-A- 388,343 photosensitizer and 9 grams of "Tetronic 1501" hydroxy terminated nonionic polymer, supplied by the BASF corporation.

The subsequent procedure for baking, UV exposure, PEB and developing are identical to that of Example 1.

### Example 4:

A photoresist coating of about 1 micrometer thick was prepared by the spin coating technique from a solution of a 18 grams of poly (4-t-Butoxy CarbonyloxyStyrene-co- 4-Hydroxystyrene) (PBOCST-PHOST) resin made in accordance with the disclosure of US-A- 366 590 76 grams of polyethyene glycol methyl ether acetate( PMA) solvent and 2 grams of trifluoromethylsulfonyl oxyicyclo - [ 2.2.1.]-hept-5-ene 2,3-dicarboximide(MDT), which is made in accordance with of US-A- 388 343 photosensitizer and 4 grams of "PPG" hydroxy terminated nonionic polymer, supplied by the Polyscience Corporation. The subsequent procedure for baking, UV exposure, PEB and developing are identical to that of Example 1.

### Exemple 5

A photoresist coating of about 1 micrometer thick was prepared by the spin coating technique from a solutionof a18 grams of poly (4-t-butoxycarbonyloxystyrene-co-4hydroxxystyrene) (PBOCST-PHOST) resin made in accordance with the disclosure of EP-A-366 590 78.8 grams of polyethyene glycol methyl ether acetate (PMA) solvent and 2 grams of trifluoromethylsulfonyloxyi-cyclo- [2.2.1.] - hept-5-ene-2,3-dicar boximide (MDT) which is made in accordance with EP-A- 388 343 photosensitizer, and 1.2 grams of "Tetronic 1501" hydroxy terminated nonionic polymer, supplied by the BASF Corporation.

The subsequent procedure for baking, UV exposure, PEB and developing are identical to that of Example 1. A comparison of process latitude with respect to dose and focus control for a chemically amplified resist system with and without the hydroxy terminated polyglycol is shown in Table 1.

**TABLE 1**

| Photoresist | % Nonionic (mJ) | Dose Window | Sensitivity |
|---|---|---|---|
| Example 1 | 0 | ± 5% | 2-3 |
| Example 2 | 1.2% | ± 20% | 5-6 |

The result clearly show that the control chemically amplified resist from Example 1, which does not contain any of the nonionic polyglycol exhibits far reduced process latitude with respect to does and focus and control of depth of focus. A sensitivity value of 5-6 is suitable sensitivity for deep UV imaging applications. Similarly an increase in dose latitude from ± 5% to ± 20% represents a significant increase in process latitude.

A comparison of the performance of the resist compositions from examples 1 to 4, comparing vertical side wall test for effects of contamination and contrast values, are given in table 2.

The "Vertical Sidewall NMP Contamination test" for control of linewidth ( NMP Exposure), as shown in table 1, is now described .

Image line width control is commonly known as critical dimension control ( CD ) . It is important to maintain the CD control to within 10 percent at all times. Thus if the targeted goal is 0.4 micron lines, linewidths between 0.36 and 0.44 are acceptable.

As noted earlier, chemically amplified photoresists are prone to critical dimension control failure, due to environmental contamination. The following environmental poison exposure test was developed to establish that the addition of the hydroxy terminated non-ionic surfactants function effectivly in maintaining critical linewidth control.

Two wafers are coated. One wafer is kept in a nitrogen atmosphere until exposed and post exposure baked ( PEB). The second wafer is environmentally contaminated by is placed over a 1000 ml. beaker containing 5 grams of N methyl pyrolidone absorbed on 45 grams of Aluminum Oxide carrier, for 60 seconds.

Both wafers are then exposed to the UV source, post exposure baked and developed as described above in Example 1. The uncontaminated wafer is examined and an optimal dose is chosen, the same spot on the contaminated wafer is similarly chosen. The wafers are then cross sectioned and scanning electron microscopy ( SEM ) photos are made of the 0.45 micron images. The contaminated wafer linewidth must vary by more than 10 percent of the control 0.45 line width and side wall quality from top to bottom must be comparable. If there is greater than a +/- 10 % variation in linewidth as compared to the control, it represents a "Failure".

Table 2 also lists a comparison of the contrast obtained with the photoresists from examples 1 to 4. It well established that as the ,"gamma values", of the photoresist increase, the more superior line width control can be obtained. This affords improved processing latitude in photo resist imaging. Values of gamma of 2-3 are considered unsatifactory while values of 5-6 are highly desirable. For example, the addition of these non-ionic surfactants, of the type and level shown in examples 2,3,and 4 show an increases in the gamma( Contrast) from a typical unsatisfactory photoresist contrast gamma value of 2- 3 to the highly desirable levels of value of 5 -6.

In addition to Table 2 also lists values for the depth of focus. The control of Example 1 is compared with Example 3 which contains 9.0% "Tetonics" non-ionic surfactant. The results demonstrate that there is a significant broadeening or increase of the focus window from 1.75 microns to 3.1 microns.

**TABLE II**

| Photoresist | % Nonionic | NMP Exposure text | Contrast (gamma) | Depth Focus (µm) |
|---|---|---|---|---|
| 1. Example 1. | 0 | Fail | 2-3 | 1.75 |
| 2. Example 2 | 0.8% | Fail | 5-6 | --- |
| 3. Example 3 | 9.0% | Pass | 5-6 | 3.1 |
| 4. Example 4 | 4.0% | Pass | 5-6 | --- |

The litographic image performance of the resists of Examples 1-4 was further evaluate with respect to image and sidewall definition. Comparison of resist of Example 1 (control) to resist of Example 3 (Tetronics 1501). Each resist may be imaged and developed giving approximately 0.45 µm features (lines and spaced when thre is no environmental (aubaine) NMP poison present. However, after 7 seconds of NMP exposure the Example 1 resist has its performance degraded so that no image is resolved. On the other hand, the Example 3 formulaiton maintained superior resolution with no dimensional changes even after 250 seconds. Vertical sidewall integrity after prolonged exposure and enhanced (and useful) contrast was achieved.

The use of the non ionic polymers containing chemically amplified resist compositions, provides enhanced stabilization effect. The presence of the hydroxy terminated nonionic polymer in the resist formulation, facilitates delayed processing, thus offering a greater advantage since it provides a longer processing window than the compositions which do not contain such nonionic polymers. A comparison was done to show the effect of delay between UV exposure and post exposure bake (PEB) for Example 1, which does not contain any nonionic polymer in the resist formulation , and the Example 4 resist which contains 4% of the nonionic polymer #16276 from Polyscience Corp. in the resist formulation. A catastrophic loss of imaging in the resist of Example 1., caused by rapid latent image decay discontinuities; loss of resolution, and filing in. After 4 minutes no image could be resolved. With the same treatment of the resist in Example 4. containing 4% #16276 hydroxy terminated nonionic polyglycol from Polyscience Corp. This nonionic polymer containing resist shows virtually no loss in linewidth or profile for up to a 6 minute delay.

The effects the presence of 0.8% Tetronic nonionic surfactant was noted in comparing resists of examples 1 and 2 on the maintenance of vertical side wall integrity. The control resist from Example 1 after the normal exposure and development process described in Example 1. where the vertical sidewalls are totally were destroyed for Example 1 product, while the vertical sidewall integrity is maintained for the product of example 2. Example 2 resist had superior performance exhibiting a clear maintenance of vertical side walls, while the control, Example 1. showed both slanted walls and images not open to the substrate. The control is unsuitable since the desired subsequent etching effects could not be achieved. Example 2 resist performance clearly demonstrate the effectiveness of the "Tetronics 1501" in maintaining straight side walls.

While the invention has been described with reference to positive photoresists sensitive to ultraviolet light ( 220-290 mm), this novel method is applicable to X-ray, positive electron beam and ultraviolet light( 290-500mm), exposure as well.

## Claims

1. A chemically amplified positive resist composition comprising an alkali soluble hydroxy-substituted aromatic polymer composition, an ester of sulfonic acid with an imide or oxime and a hydroxy terminated non-ionic polyglycol type surfactant additive.

2. A photoresist composition of claim 1 wherein the ester of the sulfonic acid comprises 1 to 20 weight percent of the solids of the composition.

3. A photoresist composition of claim 2 wherein the ester of the sulfonic acid comprises 5 to 10 weight percent of the solids of the composition.

4. The photoresist composition of claim 1 which also includes an organic solvent.

5. The photoresist composition of claim 4 which comprises 10-40 weight percent solids.

6. The photoresist composition of claim 5 which comprises 15-25 weight percent solids.

7. The photoresist composition of claim 4 wherein the solvent is selected from the group consisting of propylene glycol monomethyl ether acetate, ethyl lactate, ethoxy ethyl proprionate and ethyl cellosolve acetate.

8. The photoresist composition of claim 1 wherein the alkali soluble hydroxy-substituted aromatic polymer composition has hydroxy phenyl groups.

9. The photoresist composition of claim 8 wherein the alkali soluble hydroxy-substituted aromatic polymer composition is selected from the group consisting of phenolic resins, novolak resins, hydroxystyrene resins and a combination of copolymers thereof.

10. The photoresist composition of claim 1 wherein the alkali soluble hydroxy-substituted aromatic polymer composition has hydroxy phenyl groups and t-Butoxy oxy Carbonyl phenyl groups.

11. The photoresist composition of claim 10 wherein the alkali soluble hydroxy-substituted aromatic polymer composition is a copolymer of 4-Hydroxy Styrene and t-butoxy carbonyl oxy styrene.

12. The photoresist composition of claim 1 wherein the ester of sulfonic acid with an imide or oxime is of the form 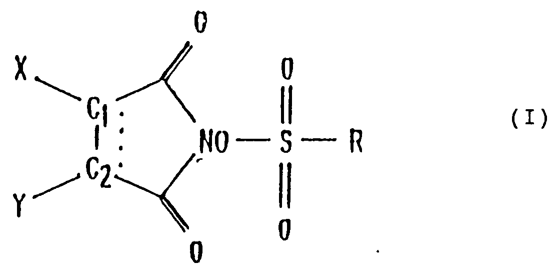 where C1 and C2 may form a single or double bond
wherein R is selected from -(CH2)n-z and -(CF2)n-z
wherein n= 0 to 4,
wherein z is H,F, alkylaryl 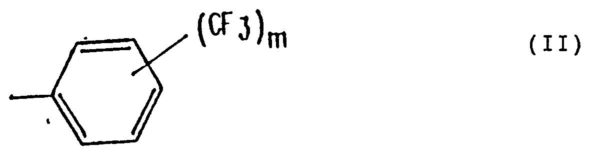 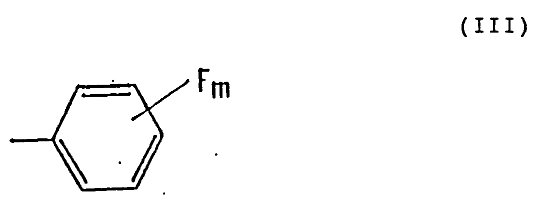 where m is from 1 to 5, provided that when z is H,F or alkylaryl n must be at least 1, and where x and y (1) form a cyclic or polycyclic ing which may contain one or more hetero atoms, (2) form a fused aromatic ring, (3) may be independently H, alkyl or aryl, (4) may be attached to another sulfonyloxyimide containing residue, or (5) may be attached to a polymeric chain or backbone.

13. The photoresist composition of claim 12 wherein the ester of a sulfonic acid with an imide or oxime is selected from the group consisting of trifluoromethylsulfonyloxybicyclo[ 2.2.1.]-hept-5-ene-2,3-dicarboximide and 1,2,3,4,5-pentafluoro - phenylsulfonyloxybiscyclo[2.2.1.]- hept-5-ene-2,3-dicarboximide.

14. The photoresist composition of claim 1 wherein the hydroxy terminated non-ionic polyglycol comprises 0.0001 to about 30 weight percent of the solids of the composition.

15. The photoresist composition of claim 14 wherein the hydroxy terminated non-ionic polyglycol comprises 1 to about 10 weight percent of the solids of the composition.

16. The photoresist composition of claim 15 wherein the hydroxy terminated non-ionic polyglycol comprises the preferred range 3 to about 5 weight percent of the solids of the composition.

17. The photoresist composition of claim 1 wherein the hydroxy terminated non-ionic polyglycol type surfactants are polymers and copolymers of glycol ethers having ethylene oxide and propylene oxide repeating units of the in the form 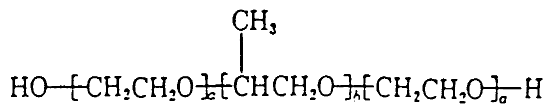 or 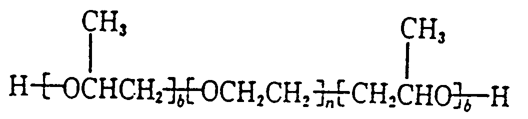 wherein "a", "b", and "n" are integers from 1 to 100; said non-ionic surfactant being intimately mixed into the positive resist resin formulation prior to its use as a positive resist coating.

18. The photoresist composition in claim 1 wherein the hydroxy terminated non-ionic polygylcol is a poly(oxyethylene-co-oxypropylene) copolymer derived from ethelene diamine as the initiating compound, in place of ethylene glycol, in the form 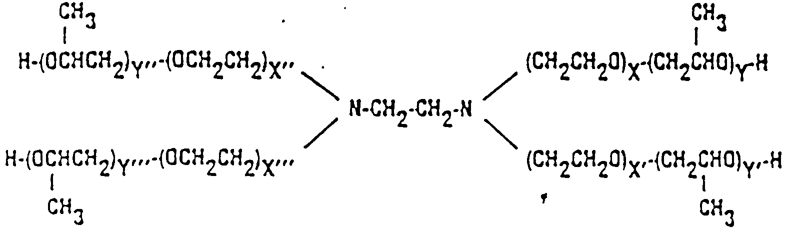 or 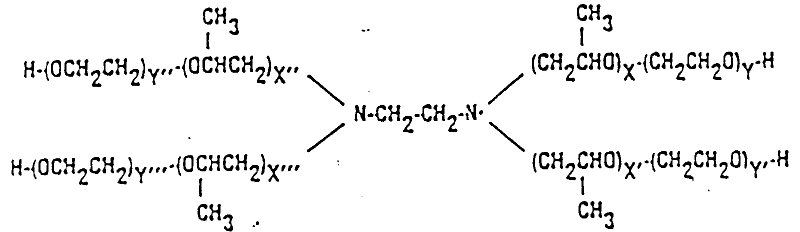 x' x'', x''', y, y'' y''', = 1 to 100

19. The photoresist composition in claim 1 wherein the resis is irradiated with X-rays.

20. The photoresist composition in claim 1 wherein the resist is irradiated with positive electron beam technique.
